# EUROPÄISCHE PATENTANMELDUNG

(11) **EP 3 056 954 A1**
(43) Veröffentlichungstag der Anmeldung: **17.08.2016**
(21) Anmeldenummer: 15154848.4
(22) Anmeldetag: 12.02.2015
(51) Int. Cl.: G05B 19/4097, G06F 17/50

(54) **Festlegen von Steuerungsinformation beim Herstellen einer Maschine**

(71) Anmelder: Siemens Aktiengesellschaft, 80333 München (DE)
(72) Erfinder: Frank, Gernot, 75365 Calw (DE)

(57) **Zusammenfassung**

Der Inbetriebnahmeaufwand einer Maschine bzw. von deren Steuerung soll vereinfacht werden. Dazu wird eine Vorrichtung und ein Verfahren zum Herstellen einer Maschine durch Entwerfen (M, E, A) der Maschine einschließlich eines Festlegens einer definierten Maschinencharakteristik, wodurch ein Entwurf entsteht, und Fertigen (F) der Maschine entsprechend dem Entwurf vorgeschlagen. Es erfolgt ein Festlegen einer Steuerungsinformation (P) für die Steuerung der Maschine in Abhängigkeit von der Maschinencharakteristik bei dem Entwerfen (M, E, A) vor Abschluss des Entwurfs und ein Ablegen der Steuerungsinformation in oder zu dem Entwurf. Auf diese abgelegte Steuerungsinformation kann dann automatisch, z. B. bei der Inbetriebnahme zurückgegriffen werden.

## Beschreibung

Die vorliegende Erfindung betrifft ein Verfahren zum Herstellen einer Maschine durch Entwerfen der Maschine einschließlich eines Festlegens einer definierten Maschinenkinematik, wodurch ein Entwurf entsteht, und Fertigen der Maschine entsprechend dem Entwurf. Darüber hinaus betrifft die vorliegende Erfindung eine entsprechende Vorrichtung zum Herstellen einer Maschine. Ferner bezieht sich die vorliegende Erfindung auf ein Verfahren zur Inbetriebnahme einer Maschine.

Kürzere Produktlebenszyklen und individuellere Produkte verlangen bei produzierenden Unternehmen eine schnellstmögliche Anpassung ihres Produktionssystems hinsichtlich einer optimierten Prozesskette. Durch neue Produktionsverfahren und integrierte Prozesse wird ein erhebliches Optimierungspotenzial freigesetzt. Dies führt zu einem steigenden Bedarf an kundenindividuellen Maschinen. Folge davon ist wiederum, dass eine entsprechende Sondermaschinenentwicklung höchst effizient gestaltet werden muss.

Gerade kleine und mittelständische Maschinenbauer entwickeln nur sehr selten wirklich konzeptionell neue Maschinen. Gerade solche Maschinenbauer, welche im Bereich der Werkzeugmaschinen tätig sind, haben sich beispielsweise häufig auf eine spezielle Kinematik der Maschinen spezialisiert. Diese und weitere Daten müssen bei der Inbetriebnahme der Steuerung, d. h. am Ende des Maschinenentwicklungsprozesses bzw. der Automatisierungsphase eingegeben werden.

Bisher müssen Maschinendaten für die Inbetriebnahme einer Maschine (z. B. Produktionsanlage, Werkzeugmaschine, Roboter etc.) meist von Hand eingegeben werden. Darüber hinaus gibt es Softwaretools, welche es ermöglichen, Inbetriebnahmedaten auf Basis einer vordefinierten Konfiguration so zusammenzustellen, dass ein Inbetriebnahmearchiv erstellt und auf die Steuerung geladen werden kann. Ein solches Softwaretool wird aber erst am Ende der Entwicklungskette von einem Automatisierer genutzt.

Die Aufgabe der vorliegenden Erfindung besteht somit darin, eine Möglichkeit zu schaffen, die Inbetriebnahme einer Maschine zu vereinfachen. Insbesondere soll dazu angegeben werden, wie eine solche Maschine hergestellt werden kann. Außerdem soll eine entsprechende Vorrichtung zur Herstellung angegeben werden.

Erfindungsgemäß wird diese Aufgabe gelöst durch ein Verfahren zum Herstellen einer Maschine durch
- Entwerfen der Maschine einschließlich eines Festlegens einer definierten Maschinencharakteristik, wodurch ein Entwurf entsteht, und
- Fertigen der Maschine entsprechend dem Entwurf, sowie
- Festlegen einer Steuerungsinformation für eine Steuerung der Maschine in Abhängigkeit von der Maschinencharakteristik bei dem Entwerfen vor Abschluss des Entwurfs und
- Ablegen der Steuerungsinformation in oder zu dem Entwurf.

Darüber hinaus wird erfindungsgemäß bereitgestellt eine Vorrichtung zum Herstellen einer Maschine mit
- einer Entwurfseinrichtung zum Entwerfen der Maschine einschließlich eines Festlegens einer definierten Maschinencharakteristik, wodurch ein Entwurf entsteht, und
- einer Fertigungseinrichtung zum Fertigen der Maschine entsprechend dem Entwurf,
   wobei
- mit der Entwurfseinrichtung eine Steuerungsinformation für eine Steuerung der Maschine in Abhängigkeit von der Maschinencharakteristik bei dem Entwerfen festlegbar und in dem Entwurf ablegbar ist.

In vorteilhafter Weise wurde also erkannt, dass Festlegungen von Maschinencharakteristiken, wie beispielsweise die Kinematik einer Maschine, bereits zu Beginn des Entwicklungsprozesses einer Maschine entstehen und die Basis für die weitere Entwicklung der Maschine, wie mechanische Ausdetaillierung und Elektrokonstruktion, sind. Solche Daten, welche bereits in einer konzeptionellen Phase bekannt sind (beispielsweise Festlegung der Maschinenkinematik) können nun auch in dieser Phase definiert werden und nachher automatisch bei der Inbetriebnahme genutzt werden. Der Aufwand bei der Inbetriebnahme wird dadurch deutlich reduziert.

Insbesondere wird also eine Steuerungsinformation, welche spezifische Maschinendaten umfassen kann, für eine Steuerung der Maschine in Abhängigkeit von der zuvor festgelegten Maschinenkinematik bzw. -charakteristik festgelegt bzw. abgespeichert, bevor der Entwurf abgeschlossen ist. Dies bedeutet, dass diese Steuerungsinformation in den weiteren Entwurf auch eingehen kann. Sie wird unmittelbar in dem Entwurf abgelegt oder in einer Datei bzw. einem Objekt, welche/welches mit dem Entwurf verknüpft ist.

Der Entwurf kann ein elektrisches, mechanisches und/oder steuerungstechnisches (bzw. automationstechnisches) Modell aufweisen. Erst all diese drei Modelle zusammen führen zu einem vollständigen mechatronischen Objekt, welches die herzustellende Maschine in allen Facetten beschreibt.

Die Steuerungsinformation kann ein Maschinendatum für einen Transformationstyp zum Umsetzen der Maschinencharakteristik enthalten. Wird also beim Entwurf eine Maschinencharakteristik (z. B. Maschinenkinematik) festgelegt, so kann davon abhängig auch der Transformationstyp gegebenenfalls automatisch bestimmt werden, mit dem die steuerungstechnischen Befehle umgesetzt werden.

Die Maschinencharakteristik kann also eine Maschinenkinematik sein. Alternativ kann die Maschinencharakteristik auch jede andere steuerungsrelevante Eigenschaft der Maschine betreffen.

Gemäß einer Ausführungsform kann einer mechanischen Baugruppe in dem Entwurf ein Attribut mit der Steuerungsinformation zugewiesen werden. Die in dem Attribut hinterlegte Steuerungsinformation kann so automatisch beispielsweise bei der Inbetriebnahme der Maschine ausgelesen und für die mechanische Baugruppe genutzt werden.

Alternativ kann auch ein Objekt des Entwurfs einer Klasse zugeordnet werden, wobei der Klasse vorgegebene Maschinendaten zugewiesen sind und als Steuerungsinformation die Maschinendaten oder ein Repräsentant dafür entsprechend der Klasse in dem Entwurf abgelegt wird. Damit kann beispielsweise eine Klassifikation von mechanischen Modellen genutzt werden, um entsprechende Steuerungsinformation bzw. Inbetriebnahmedaten passend zur Verfügung zu stellen.

In einem Ausführungsbeispiel kann die Steuerungsinformation eine Datei mit Maschinendaten umfassen und der Entwurf ein Modell der Maschine sein, wobei das Modell mit der Datei verknüpft ist. Die Steuerungsinformation kann somit beispielsweise in einer Textdatei hinterlegt sein, die dann durch Verknüpfung mit dem elektrischen, mechanischen oder steuerungstechnischen Modell verknüpft werden kann.

Eine weitere Möglichkeit, die Steuerungsinformation insbesondere für die Inbetriebnahme in den Entwurf einzubetten, besteht darin, dass der Entwurf ein logisches Objekt enthält, dem die Steuerungsinformation zugeordnet ist und das mit dem Modell oder den Modellen verknüpft ist. Somit wird in spezieller Ausprägung eine abstrakte Maschinenbeschreibung eingeführt.

Speziell kann das logische Objekt eine Parameterbeschreibung für eine Inbetriebnahme der Maschine enthalten. Somit können Daten, die beim Entwurf der Maschine bereits in früher Phase festgelegt wurden, gegebenenfalls automatisch bei der Inbetriebnahme genutzt werden.

Darüber hinaus kann, wie oben bereits angedeutet wurde, nach dem Festlegen der Maschinencharakteristik und der Steuerungsinformation im Rahmen des Entwerfens der Maschine eine Detaillierung mechanischer, elektrischer und/oder steuerungstechnischer Aspekte erfolgen. Dies bedeutet, dass die festgelegte Maschinencharakteristik bzw. die entsprechende Steuerungsinformation (z. B. für die Inbetriebnahme) bei der weiteren Verfeinerung der Modelle im Rahmen des Entwurfs mitgenutzt werden kann. Dadurch lässt sich die ein oder andere Iteration bei der Entwicklung des Entwurfs einsparen.

Erfindungsgemäß ist auch ein Verfahren zur Inbetriebnahme einer nach obigen Grundsätzen hergestellten Maschine vorgesehen, wobei die Steuerungsinformation automatisch von der Steuerung der Maschine genutzt wird. Dies bedeutet, dass bei Inbetriebnahme der Maschine die jeweiligen Parameter nicht manuell eingegeben und vorher aufwendig beschafft werden müssen, sondern dass sie von dem Entwurf bzw. mechatronischen Modell, welches dabei entstanden sein kann, übernommen werden können.

Die oben im Zusammenhang mit den verschieden ausgeprägten Verfahren geschilderten Merkmale können auch für die erfindungsgemäße Vorrichtung genutzt werden. Dabei stellen sie entsprechende funktionale Merkmale dar, die den jeweiligen Einrichtungen bzw. Mitteln zugeschrieben werden.

Die vorliegende Erfindung wird nun anhand der beigefügten Zeichnungen näher erläutert, in denen zeigen:
- FIG 1: einen Maschinenentwicklungsprozess in schematischer Ansicht gemäß der vorliegenden Erfindung;
- FIG 2: eine konzeptionelle Darstellung einer CA-Kopfkinematik und
- FIG 3: eine Verknüpfung eines Parametersatzes für die CA-Kopfkinematik mit anderen Modellen.

Die nachfolgend näher geschilderten Ausführungsbeispiele stellen bevorzugte Ausführungsformen der vorliegenden Erfindung dar. Dabei ist zu beachten, dass die geschilderten Merkmale nicht nur in der jeweils geschilderten Kombination, sondern auch beispielsweise in Alleinstellung oder in anderen technisch sinnvollen Kombinationen realisiert werden können.

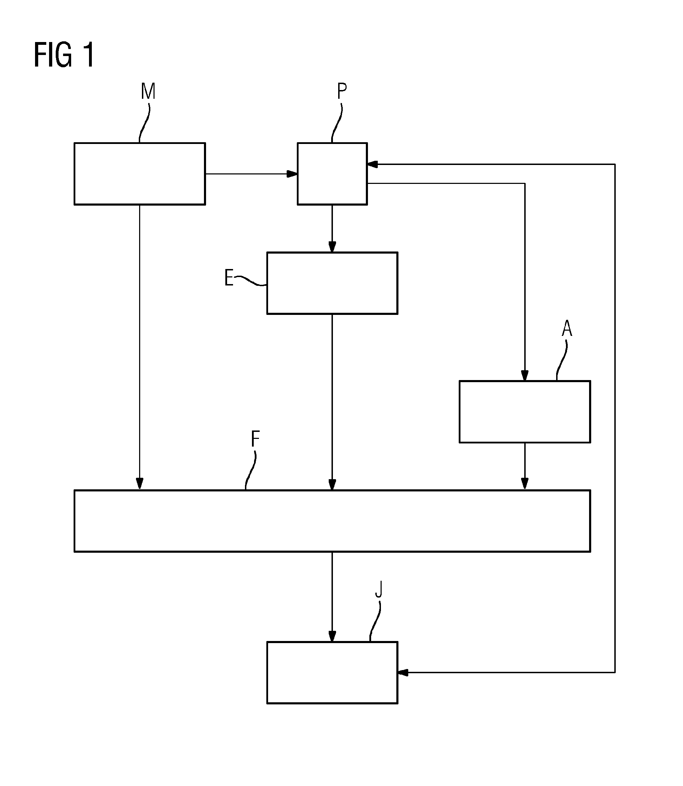

Bei der Entwicklung von elektrischen Maschinen, insbesondere Werkzeugmaschinen, Fertigungsanlagen oder Robotern, unterscheidet man die Disziplinen Mechanik, Elektrik und Automatisierung, die meist ineinandergreifend auf den Entwicklungsprozess Einfluss nehmen. In FIG 1 ist ein solcher Maschinenentwicklungsprozess beispielhaft dargestellt. Ausgehend von einem Anforderungskatalog, der hier nicht dargestellt ist, werden im Rahmen einer mechanischen Konstruktion M Zeichnungen bzw. 3D-Modelle auf Basis der gewünschten Maschinenkinematik erstellt. Meist ist die mechanische Konstruktion M am Beginn der Entwicklungszeit angesiedelt. In der Regel zeitlich etwas nachgeschaltet erfolgt die Elektrokonstruktion E. Dabei werden Schaltpläne und Elektrodokumentationen erstellt. Wiederum etwas später beginnt üblicherweise die Entwicklung der Automatisierung A, bei der Steuerungsprogramme und gegebenenfalls ein IBN-Archiv auf Basis von Maschinendaten erstellt werden. Diese zeitliche Abfolge von mechanischer Konstruktion M, Elektrokonstruktion E und Automatisierung A ist jedoch nur als grober Anhaltspunkt zu sehen. Tatsächlich sind diese Entwicklungsbausteine meist stark ineinander verwoben.

Nach Abschluss der Konstruktions- bzw. Entwicklungsphase steht ein Entwurf für die entwickelte Maschine bereit. Dieser Entwurf dient als Grundlage für eine Fertigung F dieser Maschine. Der Entwurf umfasst in der Regel ein mechanisches Modell, ein elektrisches Modell und ein Automatisierungsmodell. All diese Modelle werden für die Bearbeitung der Stücklisten und für die tatsächliche Herstellung der Maschine herangezogen. Am Ende des Fertigungsprozesses F steht eine in ihren Komponenten vollständige Maschine, die aber noch nicht betriebsbereit ist. Diese Maschine ist daher einer sogenannten Inbetriebnahme I zu unterziehen.

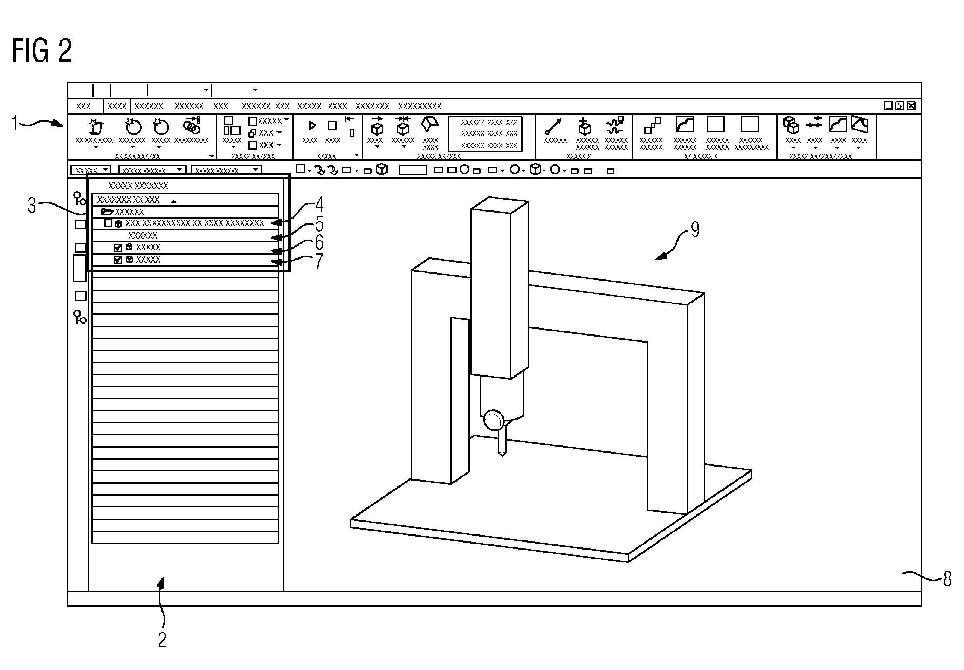

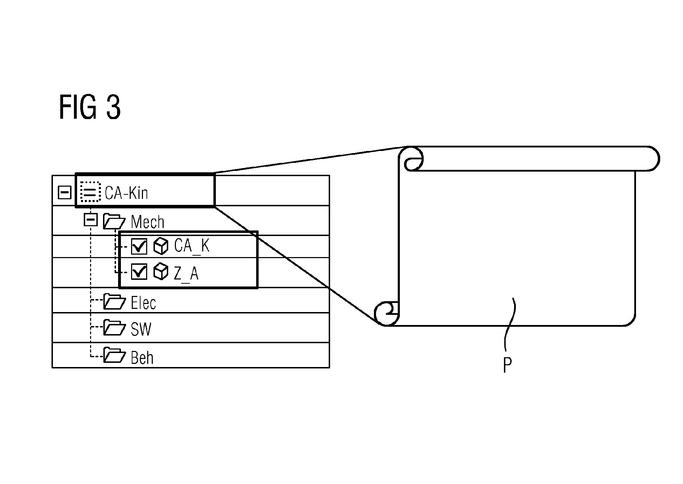

Bislang waren sämtliche Daten bei der Inbetriebnahme manuell in die Maschine einzugeben bzw. einzulesen. Dies ist in der Regel mit einem hohen Aufwand verbunden. Die Inbetriebnahmedaten umfassen in der Regel Parameter, die mit den Charakteristiken der Maschine fest verbunden sind. Diese Charakteristiken der Maschine werden aber häufig in einem frühen Entwicklungsstadium bereits festgelegt. Eine solche festgelegte Maschinencharakteristik bedingt dann für die Inbetriebnahme I einen speziellen Parameter bzw. Parametersatz P. Beispielsweise handelt es sich bei der Maschinencharakteristik um eine spezifische Maschinenkinematik. Insbesondere kann dadurch die Kinematik der Achsen der Maschine gekennzeichnet werden. Im konkreten Beispiel der FIG 2 und 3 ist als Maschinencharakteristik eine CA-Kinematik festgelegt. Es handelt sich also um die Kinematik der dort entwickelten Maschine bezüglich der Rundachsen C und A, d. h. die Umdrehungen um die Z-Achse und die X-Achse.

Wird also in dem konkreten Beispiel bei der mechanischen Konstruktion M die beispielhafte CA-Kinematik festgelegt, so ergibt sich ein entsprechender Parametersatz P, wie dies in FIG 1 angedeutet ist. Dieser Parametersatz P und damit die zugrundeliegende Maschinencharakteristik bzw. Maschinenkinematik wirkt sich auf die Elektrokonstruktion E ebenso aus wie auf die Automatisierung A.

Bei der Inbetriebnahme I kann nun vorteilhafterweise auf den Parametersatz P zurückgegriffen werden, welcher bereits im Stadium der Konstruktion ermittelt und bereitgestellt wurde. Dies bedeutet, dass dieser oder diese Parameter, die die Maschinencharakteristik bzw. Maschinenkinematik kennzeichnen, automatisch übernommen bzw. eingelesen werden können. Damit entfällt eine aufwendige manuelle Eingabe von Parametern bei der Inbetriebnahme I.

In FIG 2 ist exemplarisch ein Konzept-Designer-Tool für mechatronische Vorrichtungen dargestellt. Während in einer sogenannten Toolbar 1 Optionen und Designelemente wählbar sind, kann in einer Navigatorleiste 2 ein mechatronisches Objekt 3 in Baumstruktur wiedergegeben werden. Dieses mechatronische Objekt 3 bezieht sich beispielsweise auf eine sogenannte "CA-Kopfkinematik" 4. Diese unterliegt beispielsweise Anforderungen bzw. Randbedingungen 5. Konkretisiert wird diese CA-Kopfkinematik 4 unter der Randbedingung 5 beispielsweise mit einer Z-Achse 6 und einem CA-Kopf 7.

Auf einer Bildfläche 8 des Konzept-Designer-Tools neben der Navigatorleiste 2 und unterhalb der Toolbar 1 ist hier beispielhaft ein Modell 9 der CA-Kopfkinematik dargestellt. Der Werkzeugkopf soll zum einen entlang der Z-Achse verschiebbar sein und zum anderen um die X-Achse und die Z-Achse gedreht werden können. Die entsprechenden Merkmale 6 und 7 dieser Baugruppe sind in der Navigatorleiste 2 in der dortigen Baumstruktur des mechatronischen Objekts 3 abgelegt.

Derartige Baugruppen bzw. Kinematiken, die eine entsprechende Maschinencharakteristik kennzeichnen, können vielfältig sein. In der Regel wird die Maschinencharakteristik auch nicht nur durch eine einzige Baugruppe bestimmt. Vielmehr besitzen komplexere Maschinen und insbesondere auch Sondermaschinen oder Anlagen häufig eine Vielzahl an Kinematiken bzw. mechanischen, mechatronischen und/oder elektrischen Baugruppen, die jeweils die gesamte Maschinencharakteristik beeinflussen.

Der Einsatzbereich der vorliegenden Erfindung ist dementsprechend weitreichend. Grundsätzlich lässt sich damit beinahe jede Maschine herstellen. Besonders vorteilhaft ist natürlich die Herstellung von Sondermaschinen mit geringer Stückzahl. Bei diesen Maschinen ist der Entwicklungsaufwand gegenüber den übrigen Herstellungskosten verhältnismäßig hoch. Ein typisches Beispiel einer solchen Sondermaschine wäre eine Firmwarelademaschine, von der weltweit nur eine einzige hergestellt wurde. Eine weitere Möglichkeit für den Einsatz der vorliegenden Erfindung wäre bei der Herstellung von Maschinen denkbar, die zur Schleifwalzenproduktion dienen. Es können aber auch Großmaschinen und Anlagen von der Erfindung profitieren, wie etwa Reifenproduktionsmaschinen, Gepäckförderanlagen und dergleichen. Darüber hinaus können auch beispielsweise spezielle Roboter oder Werkzeugmaschinen mit dem erfindungsgemäßen Verfahren hergestellt werden.

Im Folgenden wird das Beispiel von FIG 2 weiter vertieft. Durch bereits konzeptionelle Festlegung, wie beispielsweise eine bestimme Maschinenkinematik (hier CA-Kopfkinematik) ist es beispielsweise möglich, sofort das Maschinendatum des Transformationstyps in der Maschinensteuerung mit einem Wert zu belegen, welcher diesen Kinematiktyp definiert. Die Transformation in der Steuerung dient dazu, Steuerungsprogramme unabhängig von der Maschinenkinematik programmieren zu können und dennoch die gewünschte Kontur zu erhalten. Dazu rechnet die Transformation Bewegungsbefehle des Werkzeuges automatisch in Bewegungsbefehle der Achsen um. Hierzu muss der Steuerung bekannt sein, welche kinematische Ausprägung die Maschine im Realen besitzt.

Soll nun der Transformationstyp bereits in der Konzeptphase festgelegt werden, so müssen dazu Erweiterungen in Konzepttools (wie beispielsweise Mechatronics Concept Designer) oder mechanischen CAD-Tools (beispielsweise NX etc.) vorgesehen werden. Technisch wären hierzu verschiedene Lösungen denkbar:
a) Einführen von Attributen in mechanischen Assemblies bzw. Baugruppen. Es kann damit einer einzelnen Baugruppe eine Steuerungsinformation spezifisch zugewiesen werden, wobei die Baugruppe die Maschinencharakteristik beeinflusst.
b) Klassifikation von mechanischen Modellen. Es lassen sich hierzu logische Objekte als Klasse definieren und jeder Klasse kann spezifisch eine entsprechende Steuerungsinformation zugewiesen werden. Auch diese klassenspezifische Steuerungsinformation lässt sich für die Inbetriebnahme nutzen.
c) Verknüpfung der mechanischen Modelle mit Maschinendaten. Es lässt sich beispielsweise ein komplettes mechanisches Modell der Maschine mit entsprechenden Parametern als Steuerungsinformation verbinden. Die Maschinendaten bzw. der entsprechende Parametersatz kann beispielsweise als Textfile auf einer Speicherplatte hinterlegt sein.
d) Einführung einer abstrakten Maschinenbeschreibung in spezieller Ausprägung, wobei beispielsweise ein spezifischer Parametersatz einer so beschriebenen Baugruppe zugewiesen wird.

Eine mögliche Implementierung der Lösung d) wäre beispielsweise ein logisches Objekt CA-Kin des MCD (Mechatronics Concept Designer) verknüpft mit einem mechanischen Modell Mech, wie dies beispielhaft in FIG 3 dargestellt ist. Dabei ist als das logische Objekt exemplarisch eine CA-Kinematik definiert. Die konzeptionellen Festlegungen sind also in Form eines Objekts verkörpert. Beispielsweise können solche Festlegungen durch Zuweisung der Modelle zu dem abstrahierten Objekt CA-Kin erfolgen. In dem Beispiel von FIG 3 sind die mechanischen Modelle Mech und Elec beispielhaft dargestellt. Das logische Objekt CA-Kin weist außerdem noch Teilobjekte bezüglich spezifischer Software SW und sonstiger Eigenschaften Beh auf.

Das logische Objekt CA-Kin enthält Parameterbeschreibungen für die Inbetriebnahme in Form eines Parametersatzes, der bereits in Zusammenhang mit FIG 1 beschrieben wurde. Diese Parameterbeschreibungen können durch Attribute oder wiederum neue Objekte realisiert werden. Dadurch erreicht man, dass vorab definierte Festlegungen in Konzeptphasen in der Inbetriebnahme genutzt werden können.

Ein wesentlicher Vorteil des erfindungsgemäßen Verfahrens bzw. einer entsprechenden Vorrichtung mit Entwurfseinrichtung und Fertigungseinrichtung liegt darin, dass konstruktive Entscheidungen, welche entlang des Entwicklungsprozesses getroffen worden sind (beispielsweise schon in einer sehr frühen Phase) und bisher lediglich der Diskussion zwischen Projektbeteiligten dienen, nun automatisch mit Daten verknüpft werden, welche am Ende des Entwicklungsprozesses bzw. bei der Inbetriebnahme eingegeben werden müssen. Dadurch reduziert sich der Inbetriebnahmeaufwand der Steuerung für die Maschine erheblich, vor allem, wenn sich diese mittel- bzw. langfristig nicht ändern. Außerdem sind die Daten konsistent, da diese entlang der gesamten Entwicklung diskutiert wurden.

## Patentansprüche

1. Verfahren zum Herstellen einer Maschine durch
- Entwerfen (M, E, A) der Maschine einschließlich eines Festlegens einer definierten Maschinencharakteristik, wodurch ein Entwurf entsteht, und
- Fertigen (F) der Maschine entsprechend dem Entwurf, **gekennzeichnet durch**
- Festlegen einer Steuerungsinformation (P) für eine Steuerung der Maschine in Abhängigkeit von der Maschinencharakteristik bei dem Entwerfen (M, E, A) vor Abschluss des Entwurfs und
- Ablegen der Steuerungsinformation in oder zu dem Entwurf.

2. Verfahren nach Anspruch 1, wobei der Entwurf ein elektrisches, mechanisches und/oder steuerungstechnisches Modell aufweist.

3. Verfahren nach Anspruch 1 oder 2, wobei die Steuerungsinformation (P) ein Maschinendatum für einen Transformationstyp zum Transformieren von Steuerungsbefehlen enthält.

4. Verfahren nach einem der vorhergehenden Ansprüche, wobei die Maschinencharakteristik eine Maschinenkinematik ist.

5. Verfahren nach einem der vorhergehenden Ansprüche, wobei einer mechanischen Baugruppe in dem Entwurf ein Attribut mit der Steuerungsinformation (P) zugewiesen wird.

6. Verfahren nach einem der vorhergehenden Ansprüche, wobei ein Objekt des Entwurfs einer Klasse zugeordnet wird, der Klasse vorgegebene Maschinendaten zugewiesen sind und als Steuerungsinformation (P) die Maschinendaten oder ein Repräsentant dafür entsprechend der Klasse in dem Entwurf abgelegt wird.

7. Verfahren nach einem der vorhergehenden Ansprüche, wobei die Steuerungsinformation (P) eine Datei mit Maschinendaten umfasst und der Entwurf ein Modell der Maschine, und wobei das Modell mit der Datei verknüpft ist.

8. Verfahren nach einem der Ansprüche 2 bis 7, wobei der Entwurf ein logisches Objekt (CA-Kin) enthält, dem die Steuerungsinformation zugeordnet ist und das mit dem Modell oder den Modellen verknüpft ist.

9. Verfahren nach Anspruch 8, wobei das logische Objekt (CA-Kin) eine Parameterbeschreibung für eine Inbetriebnahme (I) der Maschine enthält.

10. Verfahren nach einem der vorhergehenden Ansprüche, wobei nach dem Festlegen der Maschinencharakteristik und der Steuerungsinformation (P) im Rahmen des Entwerfens der Maschine eine Detaillierung mechanischer, elektrischer und/oder steuerungstechnischer Aspekte erfolgt.

11. Verfahren zur Inbetriebnahme (I) einer nach einem Verfahren gemäß einem der vorhergehenden Ansprüche hergestellten Maschine, wobei die Steuerungsinformation (P) automatisch von der Steuerung der Maschine genutzt wird.

12. Vorrichtung zum Herstellen einer Maschine mit
- einer Entwurfseinrichtung zum Entwerfen (M, E, A) der Maschine einschließlich eines Festlegens einer definierten Maschinencharakteristik, wodurch ein Entwurf entsteht, und
- einer Fertigungseinrichtung zum Fertigen (F) der Maschine entsprechend dem Entwurf,
**dadurch gekennzeichnet, dass**
- mit der Entwurfseinrichtung eine Steuerungsinformation (P) für eine Steuerung der Maschine in Abhängigkeit von der Maschinencharakteristik bei dem Entwerfen (M, E, A) festlegbar und in dem Entwurf ablegbar ist.
